## Europäisches Patentamt

## European Patent Office

## Office européen des brevets

(11) Veröffentlichungsnummer: **0 193 765**
**A2**

(12) # EUROPÄISCHE PATENTANMELDUNG

(21) Anmeldenummer: **86101906.5**

(22) Anmeldetag: **14.02.86**

(51) Int. Cl.⁴: **G 06 F 5/06**

(30) Priorität: **01.03.85 DE 3507326**

(43) Veröffentlichungstag der Anmeldung: **10.09.86**
**Patentblatt 86/37**

(84) Benannte Vertragsstaaten: **CH FR GB LI NL SE**

(71) Anmelder: **Siemens Aktiengesellschaft Berlin und München, Wittelsbacherplatz 2, D-8000 München 2 (DE)**

(72) Erfinder: **Jensen, Peter-Grauer, Starupvej 225, DK-08340 Malling (DK)**

(54) **Anordnung zur zeitverzögerten Weiterleitung von seriell auftretenden digitalen Datenfolgen.**

(57) Die Verzögerung der Datenfolge wird mit einer adressierbaren Schreib-/Lese-Speichereinheit (RAM) erzielt. Bezogen auf jeden der jeweils adressierten Speicherplätze S wird während ein und derselben Bitzeitspanne die im Speicherplatz enthaltene Information ausgelesen und die diese Bitzeitspanne zugeordnete Bitinformation eingeschrieben. Dies erfolgt solange fortlaufend für die unmittelbar aufeinanderfolgenden Speicherplätze bis die Gesamtsumme der Bitzeitspannen der verarbeiteten Bitinformationen der gewünschten Verzögerungszeit entspricht. Zur Adressierung wird ein Zähler verwendet, der durch den Bittakt jeweils um einen Stellenwert erhöht wird.

SIEMENS AKTIENGESELLSCHAFT          Unser Zeichen:
Berlin und München                  VPA **85** P **1 1 2 0** E

Anordnung zur zeitverzögerten Weiterleitung von seriell
auftretenden digitalen Datenfolgen.

Die Erfindung betrifft eine Anordnung zur zeitverzögerten Weiterleitung von seriell auftretenden digitalen
Datenfolgen, insbesondere von pulscodemodulierten
Datenfolgen, unter Verwendung einer Schreib-/Lese-Speichereinheit mit einer Vielzahl von einzeln adressierbaren Speicherplätzen.

In der Digitaltechnik wird als Speichertype  zur Taktanpassung ein FIFO-Speicher verwendet. Es kann damit
beispielsweise der Datentakt der bei einer Vermittlungsstelle ankommenden digitalen Informationsfolge an
den internen Takt dieser Vermittlungsstelle angepaßt
werden. Die Daten werden auf einen Einschreibimpuls hin
eingespeichert und können in der Reihenfolge der Eingabe durch ein entsprechendes Steuersignal ausgelesen
werden. Die Adressenlogik ist entsprechend auszulegen
und erfordert beispielsweise zwei Binärzähler. Ist eine
fest vorgegebene Verzögerungszeit für die Verzögerung
der digitalen Datenfolge erforderlich, so kann hierzu
grundsätzlich ein Schieberegister verwendet werden.
Will man eine im Vergleich zu der Taktperiodenzeit der
zu verzögernden Datenfolge wesentlich größere Verzögerungszeit  erreichen, so müßte ein Schieberegister
mit einer enorm großen Anzahl von Schiebeschritten eingesetzt werden. Im Regelfall müßten hierzu mehrere
handelsübliche Schieberegister entsprechend zusammengeschaltet werden. Für bestimmte Einsatzfälle wäre
dies eine kostenungünstige Lösung, wobei die erforderliche aufwendige  Ansteuerlogik darüber hinaus nachteilig ist.

Rs 1 Ky/ 05.02.85

Es ist die Aufgabe der Erfindung eine einfache und mit kostengünstigen Einheiten zu realisierende Anordnung zur Verzögerung einer digitalen Datenfolge um eine gleichbleibende konstante Verzögerungszeit anzugeben, wobei eine Schreib-Lese-Speichereinheit eingesetzt werden soll. Dies wird dadurch erreicht, daß bezogen auf jeden der jeweils adressierten Speicherplätze während ein und derselben Bitzeitspanne die im Speicherplatz enthaltene Information ausgelesen und die dieser Bitzeitspanne zuzuordnende Bitinformation eingeschrieben wird, daß dieses Auslesen und Einschreiben je Bitinformation solange fortlaufend in unmittelbar aufeinanderfolgende Speicherplätze vorgenommen wird, bis die Gesamtsumme der Bitzeitspannen der eingelesenen Bitinformationen der gewünschten Verzögerungszeit entspricht, daß jeweils die nachfolgenden Bitinformationen in gleicher Weise beginnend mit dem zuerst beanspruchten Speicherplatz eingeschrieben und somit mit dem Auslesen der jeweils darin enthaltenen Bitinformation diese mit der gewünschten konstanten Verzögerungszeit zur weiteren Verarbeitung zur Verfügung steht.

Es kann ein handelsüblicher frei adressierbarer Schreib-Lesespeicher - RAM - eingesetzt werden. Da während der Taktperiode des Datentaktes überlappungsfrei sowohl ausgelesen als auch eingeschrieben wird, ist für die Generierung der jeweiligen Adresse nur ein einziger Adressenlogikbaustein z.B. in Form eines binären Zählers erforderlich. Dessen Zählerstand wird mit dem Datentakt jeweils um eine Werteinheit erhöht. Damit wird mit jeder Taktperiode der jeweils nächste Speicherplatz adressiert.

Das erfindungsgemäße Verfahren wird anhand der Figuren dargestellt. Es sind nur die zum Verständnis erforderlichen Einzelheiten gezeigt.

Fig. 1 zeigt das Blockschaltbild einer Anordnung zur
   Verzögerung einer Datenfolge,

Fig. 2 zeigt eine Diagrammdarstellung einzelner Datenfolgen an bestimmten Schaltungspunkten der Anordnung nach Fig. 1.

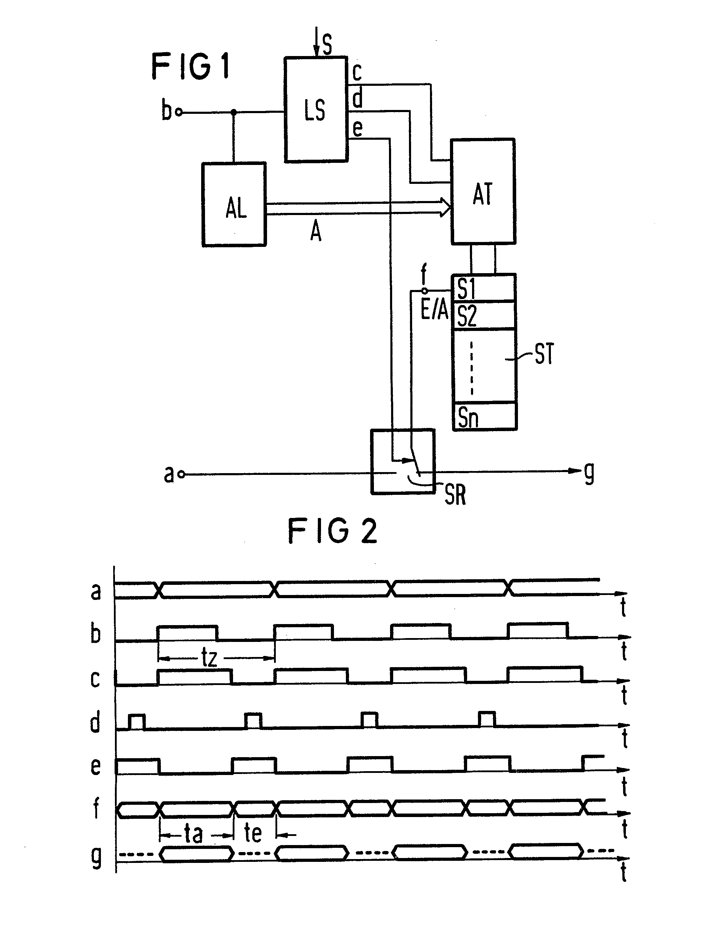

Am Schaltungspunkt a der Anordnung nach der Figur 1 soll eine serielle digitale Datenfolge auftreten. Eine solche Datenfolge ergibt sich beispielsweise aus der Umsetzung von analogen Fernsprechsignalen mit Hilfe der Pulscodemodulation in digitale Signale. Sie hat also beispielsweise eine Taktfrequenz von 64 kHz. Die Datenfolge soll zur Weiterverarbeitung am Schaltungspunkt g erst nach einer bestimmten Verzögerungszeit, die ein Vielfaches der Taktperiodenzeit entspricht, auftreten. Die Verzögerung einer solchen digitalen Signalfolge ist beispielsweise dann erforderlich, wenn ggf. nach einer Umwandlung in eine komprimiertere Form die digitalen Sprachsignale in einer Speicheranordnung abgespeichert werden sollen und in der Datenfolge auch zwischen den Sprachinformationen Steuerinformationen enthalten sind. Es soll dabei verhindert werden, daß diese Steuerinformationen in die Speichereinrichtung miteingespeichert werden. Aus diesem Grunde wird die eintreffende Signalfolge einer Auswerteeinheit zugeführt, die Steuerinformationen erkennt. Mit dem Erkennen dieser Steuerinformation unterbleibt dann während der Zeit ihres Auftretens die Einspeicherung in der·Speichereinrichtung. Es ist also für die Weiterleitung der pulscodemodulierten Signalfolge eine Verzögerungszeit vorzusehen, die der Zeitspanne entspricht, die notwendig ist, damit die Auswerteeinrichtung eine Steuerinformation eindeutig als solche erkennen kann. Hierzu sind beispielsweise Verzögerungszeiten von einigen 10 ms erforderlich.

VPA **85 P 1120** E

Die Verzögerung der am Schaltungspunkt a anliegenden Datenfolge wird mit einer Schreib-/Lese-Speichereinheit erzielt, der aus dem Ansteuerteil AT und dem Speicherteil ST besteht. Jeder jeweils adressierbare Speicherplatz einer solchen RAM-Speichereinheit weist in der Regel mehrere Speicherelemente, z.B. acht Speicherelemente auf. Im Zusammenhang mit der Verzögerung wird hiervon pro Speicherplatz nur ein Speicherelement beansprucht. Der Speicherteil ST dieser Speichereinheit soll einen bidirektionalen Anschluß E/A aufweisen. Über diesen Anschluß können Informationen in die Speichereinheit eingeschrieben bzw. aus der Speichereinheit ausgelesen werden. Die RAM-Speichereinheit wird durch die Adressenlogik AL über den Adressenbus A adressiert. Der Adressenlogik wird in gleicher Weise wie der Lese-/Schreib-Ablaufsteuerung LS der am Schaltungspunkt b anliegende Datentakt zugeführt. Die Adressenlogik kann im wesentlichen aus einem binären Zähler bestehen, der durch den Datentakt zyklisch um einen Zählwert erhöht wird. Es werden dann die einzelnen Speicherplätze S1 bis Sn des Speicherteils ST der Speichereinheit nacheinander adressiert. Der Datentakt, durch dessen 0/1-Übergänge jeweils die Zeitspanne für eine Bitinformation festgelegt ist, kann über eine eigene Leitung geliefert werden oder auch aus dem empfangenen Signal gewonnen werden. Der Einheit LS wird neben dem als Rücksetzinformation dienenden Datentakt noch ein Steuertakt an S zugeführt. Dieser muß eine höhere Frequenz als der Datentakt aufweisen.

In der Lese-/Schreibablaufsteuerung werden drei Signale generiert. Das am Schaltungspunkt c auftretende Lesesignal und das am Schaltungspunkt d auftretende Schreibsignal beeinflussen über das Ansteuerteil AT die Ein- bzw. Ausspeichervorgänge der RAM-Speichereinheit. Das am Schaltungspunkt e auftretende Schaltersignal legt die Schaltstellung des symbolisch dargestellten elektronischen Schalters SR fest. Je nach Schalterstellung wird bezogen auf eine jede Bitzeitspanne entweder die gespeicherte Information über den Anschluß E/A ausgelesen oder es wird die über den Schaltungspunkt a anliegende Dateninformation eingeschrieben. Dies könnte beispielsweise in der Zeitspanne erfolgen, in der das Schaltsignal den Wert 1 aufweist. In der Zeitspanne, in der das Schaltsignal den Wert 0 hat könnte, wie dies in der Zeichnung dargestellt ist, ausgelesen werden. Am Ausgang g entsteht dann das entsprechende "1"- bzw. "0"- Signal.

Zumindest in den Fällen, in denen das Lesesignal nicht durch einen entsprechend aktivierten Haltespeicher innerhalb einer Bitzeitspanne aufrechterhalten wird, muß das von der Lese-/Schreibablaufsteuerung generierte Lesesignal jeweils über den Zeitpunkt hinausreichen, zu dem der Datentakt beispielsweise vom binären Wert 1 zum binären Wert 0 wechselt. Dies ist in den Zeilen b und c des Diagramms nach der Fig. 2 entsprechend dargestellt. Für das in der Zeile d dieser Figur gezeigte Schreibsignal gilt, daß es sich nicht mit dem Lesesignal überlappen darf. Damit ist sichergestellt, daß während einer jeden Bitzeitspanne auf der gleichen Adresse die im Speicherplatz enthaltene Information zunächst ausgelesen und anschließend die Eingangsinformation eingeschrieben wird. Ausgelöst durch das Schreibsignal erfolgt dieses Einschreiben in der Zeitspanne, in der das Schaltsignal beispielsweise den binären 1-Zustand aufweist.

Während einer Bitzeitspanne wird jeweils aufeinanderfolgend die in einem Speicherplatz enthaltene Information ausgelesen und bei der entsprechenden Stellung des elektronischen Schalters SR die anliegende Dateninformation eingeschrieben. Diese Tatsache soll durch die Darstellung der Zeile f der Fig. 2 gezeigt werden. Die Bitzeitspanne ist beispielsweise durch den 64 kHz-Datentakt festgelegt. Beginnend mit dem Speicherplatz S1 werden die einzelnen Speicherplätze nacheinander adressiert. Die Gesamtanzahl der Speicherplätze S1 bis Sn wird bei dem vorgegebenen Datentakt durch die gewünschte Verzögerungszeit bestimmt. Bei einigen 10 ms Verzögerungszeit werden einige 1000 derartiger Speicherplätze beansprucht. Da bei einer handelsüblichen RAM-Speichereinheit jeder Speicherplatz mehrere Speicherzellen aufweist, könnten somit eine entsprechende Anzahl von getrennten digitalen Eingangsinformationen in gleicher Weise verzögert werden. Um dies zu ermöglichen, muß bei entsprechender Ansteuerung der gleiche Datentakt vorausgesetzt werden.

Ist bezogen auf eine Eingangsinformation der Speicherplatz Sn beschrieben worden, so wird für die Speicherung des nächsten Datenbits wiederum der Speicherplatz S1 herangezogen. Es wird zunächst die darin enthaltene Information bei der entsprechenden Schalterstellung des elektronischen Schalters SR ausgelesen. Die betreffende Bitinformation erscheint also nach der gewünschten Verzögerungszeit am ausgangsseitigen Schaltungspunkt g. Mit der gleichen Adresse wird dann innerhalb derselben Bitzeitspanne nach der Änderung der Schalterstellung des Schalters SR die anliegende Eingangsinformation eingeschrieben. Dieser Mechanismus setzt sich wiederum bis zur Adressierung des Speicherplatzes Sn fort und wiederholt sich zyklisch. Eine Eingangsinformation steht demnach mit der gewünschten Verzögerungszeit am Schaltungspunkt g für die Weiterverarbeitung zur Verfügung.

In der Fig. 2 sind in den Zeilen a bis g Impulsabläufe dargestellt, die teilweise bereits in der bisherigen Beschreibung erörtert wurden. Die an den Schaltungspunkten a bis g der Fig. 1 auftretenden Informationen
entsprechen den Impulsen, die in der mit dem gleichen
Bezugszeichen versehenen Zeile der Fig. 2 jeweils dargestellt sind.

Die Zeile a zeigt die Eingangsinformationen, die entweder aufeinanderfolgend den Binärwert 0 bzw. den Binärwert 1 aufweisen. Eine Bitzeitspanne wird durch den in
der Zeile b dargestellten Datentakt festgelegt. Die
Zeile c zeigt die Folge der Lesesignale und die Zeile d
die Folge der Schreibsignale. In der Zeile e ist das
den elektronischen Schalter SR beeinflussende Schaltsignal gezeigt. Innerhalb einer jeden Bitzeitspanne tz
wird gemäß Zeile f in der mit dem aktiven Lesesignal
übereinstimmenden Zeit, in der das Schaltsignal die binäre 0 aufweist, eine Information vom RAM-Baustein ausgegeben. Das entsprechende Signal mit dem Binärwert 0
bzw. mit dem Binärwert 1 erscheint am ausgangsseitigen
Schaltungspunkt g entsprechend der Zeile g. Durch einen
vorgeschalteten Haltespeicher könnte das jeweilige
Ausgangssignal so verlängert werden, daß es jeweils eine
Bitzeitspanne ausfüllt. Innerhalb ein und derselben Bitzeitspanne tz schließt sich nach dem in der Zeit t vorgenommenen Auslesevorgang gemäß Zeile f der Einschreibvorgang an. In dieser Zeitspanne te wird beim entsprechenden Schaltsignal gemäß Zeile e die jeweilige binäre Eingangsinformation in den Speicherplatz eingeschrieben.

2 Patentansprüche
2 Figuren

Patentansprüche.

1. Anordnung zur zeitverzögerten Weiterleitung von seriell auftretenden digitalen Datenfolgen, insbesondere von pulscodemodulierten Datenfolgen, unter Verwendung einer Schreib-/Lese-Speichereinheit mit einer Vielzahl von einzeln adressierbaren Speicherplätzen, d a d u r c h  g e k e n n z e i c h n e t , daß bezogen auf jeden der jeweils adressierten Speicherplätze (S1 bis Sn) während ein und derselben Bitzeitspanne (tz in Fig. 2) überlappungsfrei die im Speicherplatz enthaltene Information ausgelesen und die dieser Bitzeitspanne zuzuordnende Bitinformation eingeschrieben wird, daß dieses Auslesen und Einschreiben je Bitinformation so lange fortlaufend in unmittelbar aufeinanderfolgende Speicherpläte vorgenommen wird, bis die Gesamtsumme der Bitzeitspannen der eingelesenen Bitinformationen der gewünschten Verzögerungszeit entspricht, daß jeweils die nachfolgenden Bitinformationen in gleicher Weise beginnend mit dem zuerst beanspruchten Speicherplatz (S1) eingeschrieben und somit mit dem Auslesen der jeweils darin enthaltenen Bitinformation diese mit der gewünschten konstanten Verzögerungszeit zur weiteren Verarbeitung zur Verfügung steht.

2. Anordnung nach Patentanspruch 1, d a d u r c h  g e k e n n z e i c h n e t , daß als Schreib-/Lese-Speichereinheit ein integrierter frei adressierbarer Speicher - RAM - eingesetzt wird und daß die Adressierung der Speicherplätze durch einen binären Zähler erfolgt, dessen die jeweilige Adresse bestimmender Zählerstand jeweils mit dem Datentakt (Zeile a der Fig. 2) um jeweils eine Werteinheit erhöht wird.

0193765

1/1

FIG 1

FIG 2